# EUROPÄISCHE PATENTSCHRIFT

(11) **EP 0 842 532 B1**
(45) Veröffentlichungstag und Bekanntmachung des Hinweises auf die Patenterteilung: **02.10.2002**
(21) Anmeldenummer: 96923843.5
(22) Anmeldetag: 12.07.1996
(51) Int. Cl.: H01L 21/316, H01L 21/762

(54) **VERFAHREN ZUM ERZEUGEN EINER ABSTANDSSCHICHT IN EINER STRUKTUR**
PROCESS FOR GENERATING A SPACER IN A STRUCTURE
PROCEDE DE PRODUCTION D'UNE COUCHE D'ESPACEMENT DANS UNE STRUCTURE

(30) Priorität: 04.08.1995 DE 19528746
(43) Veröffentlichungstag der Anmeldung: 20.05.1998
(73) Patentinhaber: Infineon Technologies AG, 81669 München (DE)
(72) Erfinder: GRASSL, Thomas, D-85354 Freising (DE); ENGELHARDT, Manfred, D-83620 Feldkirchen-Westerham (DE)
(74) Vertreter: Kindermann, Peter, Dipl.-Ing.
(86) Internationale Anmeldenummer: DE9601277
(87) Internationale Veröffentlichungsnummer: WO97006556

(56) Entgegenhaltungen:
- EP-A- 0 597 603
- US-A- 5 182 221
- US-A- 5 223 736
- DATABASE WPI Section Ch, Week 9111 Derwent Publications Ltd., London, GB; Class L03, AN 91-243740 XP002012640 ANONYMOUS: "Semiconductor trench isolate deposit tetra ethyl orthosilicate film CVD produce" & RESEARCH DISCLOSURE, Bd. 327, Nr. 019, 10.Juli 1991, EMSWORTH, GB,
- SOLID STATE TECHNOLOGY, Bd. 37, Nr. 3, 1.März 1994, Seite 31/32, 34, 36, 38, 40 XP000440989 WALLACE FRY H ET AL: "APPLICATIONS OF APCVD TEOS/O3 THIN FILMS IN ULSI IC FABRICATION"
- JOURNAL OF THE ELECTROCHEMICAL SOCIETY, Bd. 136, Nr. 10, 1.Oktober 1989, Seiten 3033-3043, XP000080918 BECKER F S ET AL: "LOW PRESSURE DEPOSITION OF DOPED SIO2 BY PYROLYSIS OF TETRAETHYLORTHOSILICATE (TEOS) II. ARSENIC DOPED FILMS"

## Beschreibung

Die vorliegende Erfindung bezieht sich auf ein Verfahren zum Erzeugen einer Abstandsschicht in einer Struktur.

In der Halbleitertechnologie haben Abstandsschichten, sogenannte Spacer, große Bedeutung erlangt.

Spacer werden beispielsweise in einer Struktur, z.B. einem Loch oder einem Graben, erzeugt, um eine laterale elektrische Isolation von Löchern, Durchgängen oder Gräben herbeizuführen, sogenannte Keimschichten abzuzscheiden oder Diffusionsbarrieren einzubauen.

Als Material für die Erzeugung eines isolierenden Spacers wird typischerweise Siliziumdioxid (SiO₂) verwendet.

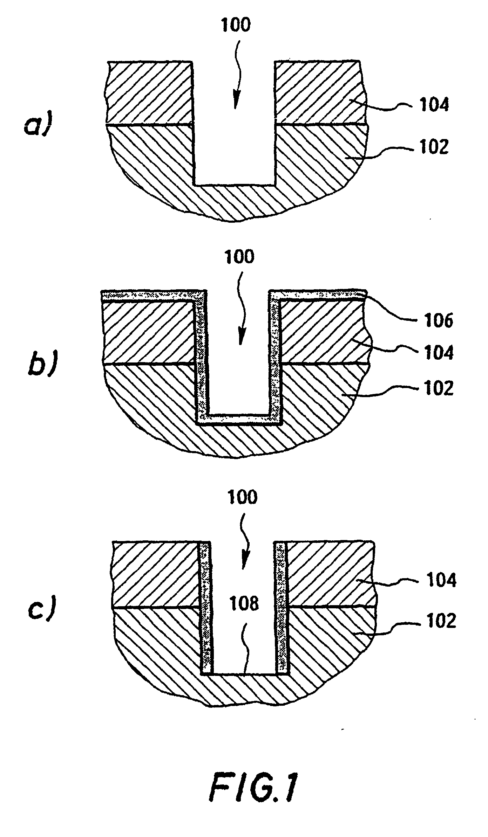

Anhand der Fig. 1 wird nachfolgend ein herkömmliches Verfahren zur Erzeugung eines SiO₂-Spacer beschrieben.

In Fig. 1 ist eine Struktur 100, die hier beispielsweise ein Graben sein kann, vor der Abscheidung des den Spacer bildenden Materials dargestellt. Die Struktur 100 ist bei dem in Fig. 1a gezeigten Beispiel in einer Mehrschichtstruktur gebildet, die aus einer ersten Schicht 102 und aus einer zweiten Schicht 104 besteht.

Die erste Schicht 102 ist typischerweise ein Siliziumsubstrat mit Transistoren (front-end), und die zweite Schicht 104 dient zur verdrahtung (Metallisierung) der Transistoren (back-end), wobei die zweite Schicht aus SiO₂ besteht, in das Metallbahnen eingebettet sind.

Nach der Bildung der Struktur 100 wird SiO₂ abgeschieden, so daß sich eine SiO₂-Schicht 106 auf der Oberfläche der Schicht 104, auf den Seitenwänden der Struktur 100 sowie auf dem Boden der Struktur 100 bildet, wie dies in Fig. 1b gezeigt ist.

Zur Fertigstellung des Spacers wird eine anisotrope Plasma-Ätzung durchgeführt, durch die der Boden 108 der Struktur 100 freigelegt wird, wie dies in Fig. 1c zu sehen ist.

Gleichzeitig wird durch die Plasma-Ätzung die SiO₂-Schicht 106 oberhalb der Schicht 104 und ein geringer Teil der Schicht 104 entfernt, da die Ätzrate auf der Oberfläche des Wafers größer ist als auf dem Boden der Struktur, wie dies ebenfalls aus Fig. 1c zu entnehmen ist.

Aus der obigen Beschreibung des aus dem Stand der Technik bekannten Verfahrens ist zu ersehen, daß dieses bekannte Verfahren zur Erzeugung eines Spacers in einer Struktur eine aufwendige Schrittfolge umfaßt, das aus den Schritten des Erzeugens der Struktur, des Abscheidens des Materials, aus dem der Spacer herzustellen ist, und aus dem Schritt des Freilegens des Bodens der Struktur durch einen Ätzvorgang besteht, wobei bei heute immer tiefer werdenden Strukturen die unterschiedlichen Ätzraten auf der Oberfläche des Wafers und auf dem Boden der Struktur ein zunehmendes Problem darstellen.

Es wird darauf hingewiesen, daß das oben beschriebene herkömmliche Verfahren aus dem Stand der Technik nicht ausschließlich zum Entfernen einer SiO₂-Schicht von einem Boden 108 einer Struktur 100 geeignet ist, sondern daß auf diese Art allgemein SiO₂-Schichten von horizontalen Gebieten entfernt werden.

Ausgehend von dem oben beschriebenen Stand der Technik liegt der vorliegenden Erfindung die Aufgabe zugrunde, ein vereinfachtes Verfahren zum Erzeugen einer Abstandsschicht in einer Struktur zu schaffen.

Diese Aufgabe wird durch ein Verfahren nach Anspruch 1 gelöst.

Die vorliegende Erfindung schafft ein Verfahren zum Erzeugen einer Abstandsschicht in einer Struktur mit folgenden Schritten:
- anisotropes Trockenätzen einer zu strukturierenden Schicht, um die Struktur zu erzeugen;
- Reinigen der Struktur von Ätzrückständen; und
- Abscheiden von Siliziumdioxid mit einem organischen Siliziumprekursor und Ozon bei einem Druck von p = 0,2 - 1 bar und einer Temperatur von 200°C bis 400°C.

Der vorliegenden Erfindung liegt die Erkenntnis zugrunde, daß das anisotrope Trockenätzen zur Erzeugung der Struktur dazu führt, daß Beschädigungen, Modifikationen und/oder Kontaminationen bzw. Implantationen vor allem auf dem Boden einer Struktur auftreten. Die zeitliche Dauer eines nachfolgenden Naßätzschritts zur Reinigung aller Oberflächen von Ätzrückständen, typischerweise mittels 1-3%iger Flußsäure (HF), muß so kurz gewählt sein, daß die Seitenwände der Struktur gesäubert sind, aber die Modifikation des Strukturbodens nicht vollständig entfernt wird. Eine geeignete Prozeßführung während der anschließenden konformen Abscheidung der den Spacer bildenden Schicht führt dazu, daß eine Abscheidung auf dem Boden der Struktur unterbleibt, so daß durch den Abscheidungsprozeß lediglich der erwünschte laterale Spacer erzeugt wird. Somit entfällt ein zusätzlicher Ätzschritt, wie er zum Abschluß des oben gewürdigten bekannten Verfahrens erforderlich ist.

Gemäß einem bevorzugten Ausführungsbeispiel der vorliegenden Erfindung erfolgt die naßchemische Reinigung typischerweise mittels einer 1-3%igen Flußsäure (HF).

Gemäß einem weiteren bevorzugten Ausführungsbeispiel der vorliegenden Erfindung erfolgt das Abscheiden der Siliziumprekursoren durch einen O₃-TEOS-CVD-Prozeß.

Weitere bevorzugte Ausgestaltungen der Erfindung sind in den Unteransprüchen definiert.

Anhand der beiliegenden Zeichnungen werden nachfolgend bevorzugte Ausführungsbeispiele der vorliegenden Erfindung näher beschrieben. Es zeigen:
- Fig. 1: eine Darstellung der zur Erzeugung einer Beabstandung notwendigen Schritte gemäß einem Verfahren nach dem Stand der Technik; und
- Fig. 2: eine Darstellung der zur Erzeugung der Beabstandung notwendigen Schritte gemäß dem Verfahren der vorliegenden Erfindung.

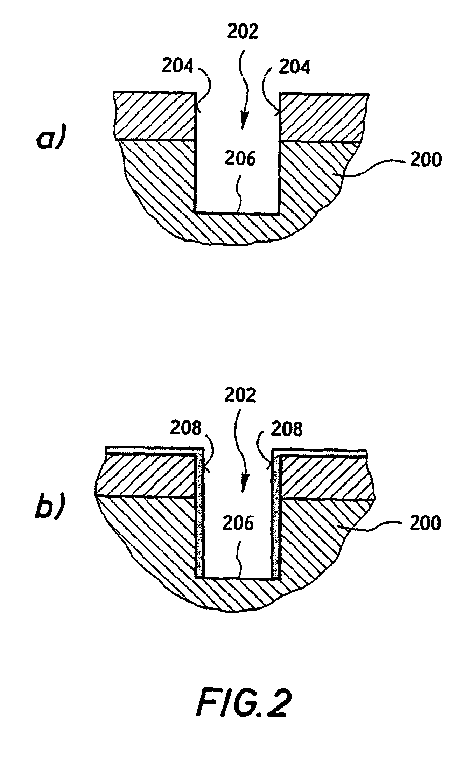

Anhand der Fig. 2 wird nachfolgend das erfindungsgemäße Verfahren näher beschrieben.

In einem ersten Schritt wird eine anisotrope Trockenätzung einer zu strukturierenden Schicht 200 durchgeführt, um die Struktur 202 zu erzeugen.

Nach diesem ersten Schritt ergibt sich eine Struktur, wie sie in Fig. 2a dargestellt ist.

Die in Fig. 2a dargestellte Struktur 202 beispielsweise in der Form eines Grabens oder eines Lochs schließt Seitenwände 204 und einen Boden 206 ein.

Bei der Schicht 200 handelt es sich beispielsweise um ein Substrat oder einen Wafer.

Es wird darauf hingewiesen, daß die zu strukturierende Schicht 200 nicht aus einer einzelnen Schicht hergestellt sein muß, sondern daß diese auch aus einer Mehrzahl von Schichten gebildet werden kann, wie dies bereits anhand der Fig. 1 beschrieben wurde.

Ferner können bereits fertig prozessierte Wafer verwendet werden.

Die Auswahl der Art der zu strukturierenden Schicht 200 hängt direkt von der vorgesehenen Anwendung ab und unterscheidet sich folglich bei unterschiedlichen Halbleiterherstellungstechnologien.

Bei dem hier beschriebenen Ausführungsbeispiel wird das anisotrope Trockenätzen durch ein anisotropes Plasma-Ätzen ausgeführt.

Durch das anisotrope Plasma-Ätz-Verfahren, durch das die Struktur 202 hergestellt wird, an deren Seitenwänden 204 der Spacer zu erzeugen ist, treten aufgrund der Anisotropie der Plasma-Ätzprozesse vor allem am Boden 206 der Struktur 202 Beschädigungen, Modifikationen und/oder Kontaminationen bzw. Implantationen auf. Daraus ergibt sich, daß bereits während der Strukturerzeugung der Boden 206 der Struktur 202 gegenüber den Seitenwänden 204 unterschiedlich vorbehandelt ist.

Diese unterschiedliche Vorbehandlung stellt ein erstes wesentliches Merkmal des Verfahrens gemäß der vorliegenden Erfindung dar. Es wird darauf hingewiesen, daß diese unterschiedliche Vorbehandlung auch durch andere anisotrope Trockenätz-Prozesse erfolgen kann.

Die auftretenden Kontaminationen und Ätzrückstände müssen nach dem Ätz-Prozeß entfernt werden. Dies kann beispielsweise durch einen naßchemischen Reinigungsschritt oder einen isotropen Plasma-Reinigungsschritt erfolgen.

In einem nächsten Schritt wird auf der zu strukturierenden Schicht 200 sowie in den Bereichen der Struktur 202 Siliziumdioxid (SiO₂) mit einem organischen Siliziumprekursor und Ozon bei einem Druck von p = 0,2 - 1 bar und einer Temperatur von 200°C - 400°C abgeschieden. Organische Siliziumprekursoren sind in Fachkreisen an sich bekannt und bezeichnen Materialien, die Silizium-Vorstufen bilden.

Dieses Abscheiden von organischen Siliziumprekursoren bei den oben angegebenen Prozeßparametern stellt eine geeignete Prozeßführung zur konformen Abscheidung des Spacers dar.

Aufgrund der oben anhand der Fig. 2a beschriebenen Prozeßführung während der Erzeugung der Struktur 202 führt die konforme Abscheidung dazu, daß auf dem Boden 206 der Struktur 202 eine Abscheidung unterbleibt. Somit wird durch die Abscheidung lediglich der Spacer 208 erzeugt, wie dies in Fig. 2b zu sehen ist.

Durch diesen Spacer ist beispielsweise eine laterale elektrische Isolation realisiert.

Gemäß einem bevorzugten Ausführungsbeispiel erfolgt die SiO₂-Abscheidung durch einen sogenannten TEOS-Prozeß mit TEOS (TEOS = Tetra Ethyl Ortho Silikat) als Siliziumprekursor.

Wiederum gemäß einem weiteren bevorzugten Ausführungsbeispiel der vorliegenden Erfindung wird der oben genannte TEOS-Prozeß durch einen O₃-TEOS-CVD-Prozeß durchgeführt. Die für diesen Prozeß erforderlichen Prozeßparameter lauten wie folgt:

| | |
|---|---|
| Abstand Wafer-Gasdusche | 5-25 mm |
| (Eine Vorrichtung zur Durchführung des O₃-TEOS-CVD-Prozesses ist aus den Fachkreisen an sich bekannt, so daß der oben angeführte Abstand zwischen dem Wafer und der Gasdusche nicht näher erläutert werden muß.) | |
| (Sauerstoff+Ozon)-Fluß | 1000 - 10.000 sccm |
| (TEOS+Helium)-Fluß | 100 - 3000 sccm |
| Ozonanteil im Sauerstoff-Ozon-Gemisch | 5 - 20 Gewichts-% |

Der O₃-TEOS-CVD-Prozeß ist ein sogenannter SACVD-Prozeß (SACVD = subatomsheric chemical vapor deposition).

Es wird darauf hingewiesen, daß neben den oben beschriebenen Gräben oder Löchern auch andere Strukturen verwendet werden können, bei denen es erwünscht ist, einen Bodenbereich dieser Strukturen freizuhalten, wohingegen auf Seitenwänden Spacer bzw. Oxidspacer gebildet werden sollen.

## Patentansprüche

1. Verfahren zum Erzeugen einer Abstandsschicht in einer Struktur, **gekennzeichnet durch** folgende Schritte:
- anisotropes Trockenätzen einer zu strukturierenden Schicht (200), um die Struktur (202) zu erzeugen, wodurch ein Boden **durch** Beschädigungen, Modifikationen und/oder Kontaminationen bzw. Implantationen gegenüber Seitenwänden (204) der Struktur (202) unterschiedlich vorbehandelt wird;
- Reinigen der Struktur (202) von Ätzrückständen; und
- Abscheiden von Siliziumdioxid mit einem organischen Siliziumprekursor und Ozon bei einem Druck von p=0,2 bis 1 Bar mit einer Temperatur von 200 °C bis 400 °C.

2. Verfahren nach Anspruch 1, **dadurch gekennzeichnet, daß** die zu strukturierende Schicht (200) ein Wafer ist.

3. Verfahren nach Anspruch 1 oder 2, **dadurch gekennzeichnet, daß** beim Schritt des Reinigens Ätzrückstände von den Seitenwänden der Struktur entfernt werden und Modifikationen des Bodens der Struktur (202) nicht entfernt werden.

4. Verfahren nach einem der Ansprüche 1 bis 3, **dadurch gekennzeichnet, daß** die zu erzeugende Struktur (202) ein Graben oder ein Loch ist.

5. Verfahren nach Anspruch 4, **dadurch gekennzeichnet, daß** der Abscheidungsprozeß durch einen O₃-TEOS-CVD-Prozeß durchgeführt wird, wobei der O₃-TEOS-CVD-Prozeß folgende Prozeßparameter aufweist:
| | |
|---|---|
| Abstand Wafer-Gasdusche | = 5 - 25 mm |
| (Sauerstoff+Ozon)-Fluß | = 1000 - 10.000 sccm |
| (TEOS+Helium)-Fluß | = 100 - 3000 sccm |
| Ozonanteil im Sauerstoff-Ozon-Gemisch: | 5 - 20 Gewichts-% |

## Claims

1. Method for the production of a spacer layer in a structure, **characterized by** the following steps:
- anisotropic dry etching of a layer (200) to be structured, in order to produce the structure (202), as a result of which a bottom is pretreated differently from side walls (204) of the structure (202) by instances of damage, modification and/or contamination or implantation;
- cleaning etching residues from the structure (202); and
- deposition of silicon dioxide with an organic silicon precursor and ozone at a pressure of p = 0.2 to 1 bar with a temperature of 200°C to 400°C.

2. Method according to Claim 1, **characterized in that** the layer (200) to be structured is a wafer.

3. Method according to Claim 1 or 2, **characterized in that**, in the cleaning step, etching residues are removed from the side walls of the structure and modifications of the bottom of the structure (202) are not removed.

4. Method according to one of Claims 1 to 3, **characterized in that** the structure (202) to be produced is a trench or a hole.

5. Method according to Claim 4, **characterized in that** the deposition process is carried out by means of an O₃-TEOS-CVD process, the O₃-TEOS-CVD process having the following process parameters:
| | |
|---|---|
| Distance between the wafer and gas spray | = 5 - 25 mm |
| (Oxygen+ozone) flow | = 1000 - 10,000 sccm |
| (TEOS+helium) flow | = 100 - 3000 sccm |
| Proportion of ozone in the oxygen/ozone mixture | = 5 - 20 % by weight |

## Revendications

1. Procédé de production d'une couche d'espacement dans une structure, **caractérisé par** les stades suivants :
- attaque anisotrope à sec d'une couche (200) à structurer pour produire la structure (202), un fond étant prétraité par endommagements, modifications et/ou pollutions et implantations, de manière différente des parois (204) latérales de la structure (202) ;
- nettoyage de la structure (202) pour en éliminer des résidus d'attaque ; et
- dépôt de dioxyde de silicium comprenant un précurseur organique de silicium et de l'ozone, sous une pression de p = 0,2 à 1 bar et à une température de 200°C à 400°C.

2. Procédé suivant la revendication 1, **caractérisé en ce que** la couche (200) à structurer est une tranche.

3. Procédé suivant la revendication 1 ou 2, **caractérisé en ce que** lors du stade de nettoyage, des résidus d'attaque sont éliminés des parois latérales de la structure et des modifications du fond de la structure ne sont pas éliminées.

4. Procédé suivant l'une des revendications 1 à 3, **caractérisé en ce que** la structure (2) à produire est un sillon ou un trou.

5. Procédé suivant la revendication 4, **caractérisé en ce que** l'opération de dépôt s'effectue par une opération CVD O₃-TEOS, l'opération CVD O₃-TEOS ayant les paramètres opératoires suivants :
distance tranche : émetteur de gaz = 5 à 25 mm
débit (oxygène + ozone) = 1000 à 10 000 cm³ à la seconde
débit (TEOS + hélium) = 100 à 3000 cm³ à la seconde
proportion d'ozone dans le mélange d'oxygène et d'ozone 5 à 20 % en poids.
